# EUROPÄISCHE PATENTANMELDUNG

(11) **EP 2 690 761 A1**
(43) Veröffentlichungstag der Anmeldung: **29.01.2014**
(21) Anmeldenummer: 12177578.7
(22) Anmeldetag: 24.07.2012
(51) Int. Cl.: H02K 11/00, H02K 15/00, G01R 31/34

(54) **Überwachungssystem für eine elektrische Maschine**

(71) Anmelder: Siemens Aktiengesellschaft, 80333 München (DE)
(72) Erfinder: Kowalski, Waldemar, 45472 Mülheim an der Ruhr (DE); Lehmann, Christoph, 47506 Neukirchen-Vluyn (DE)

(57) **Zusammenfassung**

Die Erfindung betrifft ein Überwachungssystem zur Überwachung einer elektrischen Maschine (1), wobei innerhalb der elektrischen Maschine (1) eine Minikamera (7, 8) zur Beobachtung der elektrischen Maschine (1) angeordnet ist.

## Beschreibung

Die Erfindung betrifft ein Überwachungssystem zur Überwachung einer elektrischen Maschine, wobei die elektrische Maschine ein Gehäuse und eine im Gehäuse angeordnete Ständerwicklung mit einem Ständerwickelkopf aufweist.

Elektrische Maschinen wie z.B. elektrische Generatoren sind im Wesentlichen aus einem sich beweglichen Teil, dem Ständerrotor und einem unbeweglichen Teil, dem Ständer ausgebildet. Der Rotor umfasst eine Rotorwicklung, die im Wesentlichen großvolumige Kupferleitungen sind, die über eine Erregereinrichtung mit Strom zur Erzeugung eines Magnetfeldes versorgt werden. Das sich drehende Magnetfeld induziert eine Spannung in auf dem Ständer geeignet angeordneten elektrisch leitenden Ständerwicklungen. Üblicherweise werden solche elektrischen Generatoren derart ausgeführt, dass an den Enden der Ständerwicklung die elektrischen Leitungen zu einem Ständerwickelkopf ausgebildet sind.

Während des Betriebes einer elektrischen Maschine führen verschiedene physikalische Effekte zu einer Belastung der einzelnen Bauteile. So wird zum einen durch einen elektrischen Widerstand sowohl in der Ständerwicklung als auch in der Rotorwicklung Energie dissipiert, die zu einer thermischen Beanspruchung der einzelnen Bauteile führt. Des Weiteren werden die Rotoren in der Regel bei vergleichsweise hohen Drehzahlen wie bspw. 50 bzw. 60 Hz betrieben, was zu enormen Fliehkräften und zu mechanischen Belastungen führt. Solch hohe Drehzahlen führen nicht nur zu höheren Belastungen im Rotor, sondern auch im Ständer, insbesondere im Ständerwickelkopf. Die durch die Rotation einhergehenden Vibrationen bzw. Schwingungen können die Lebensdauer solch ausgeführter elektrischer Generatoren verkürzen.

Elektrische Generatoren werden in der Regel mit Luft, Wasserstoff oder Wasser gekühlt, je nach elektrischem Leistungsbedarf. Das Kühlmedium wird in einem Gehäuse im elektrischen Generator im Wesentlichen hermetisch geführt, so dass das Gehäuse im Wesentlichen gasdicht gegenüber der Umgebung ausgebildet ist.

In der Regel werden die Generatoren auf Dauerbetrieb ausgelegt und dementsprechend ausgelastet. Bei Inspektionsarbeiten, die im Stillstand des elektrischen Generators durchgeführt werden, werden die Ständerwickelköpfe durch einen Befunder visuell inspiziert. Dazu wird ein Zugang durch eine Öffnung, bspw. durch so genannte Mannlochdeckel ermöglicht, wodurch eine visuelle Inspektion möglich wird. Dennoch sind solche Platzverhältnisse derart beengt, dass nur durch eine teilweise Demontage von weiteren Generatorkomponenten, wie z.B. der Schildlageroberteile, der Zugang zu den Ständerwickelköpfen möglich ist.

Ein weiteres Problem ist, dass insbesondere bei mit Wasserstoff gekühlten Generatoren das Kühlungsmedium (Wasserstoff) aus dem Inneren des elektrischen Generators gespült werden muss, was einen erheblichen Aufwand bedeutet. Selbst nach vermeintlich erfolgreichem Ausblasen und Spülen der elektrischen Maschine mit Inertgas muss die elektrische Maschine, bevor sie begangen werden kann, noch abgesichert werden, indem Formaldehyd und Sauerstoffkonzentrationsmessungen durchgeführt werden.

Wünschenswert wäre es eine Inspektionsmöglichkeit zu haben, die einen gegenüber dem Stand der Technik geringeren Aufwand bedeutet.

Aufgabe der Erfindung ist es daher, ein Überwachungssystem anzubieten, mit dem mit geringem Aufwand eine elektrische Maschine inspiziert werden kann.

Gelöst wird diese Aufgabe durch ein Überwachungssystem zur Überwachung einer elektrischen Maschine, wobei die elektrische Maschine ein Gehäuse und eine im Gehäuse angeordnete Ständerwicklung mit einem Ständerwickelkopf aufweist, wobei innerhalb des Gehäuses eine Minikamera zur Beobachtung der elektrischen Maschine angeordnet ist.

Die wesentliche Idee der Erfindung ist es, eine geeignete Minikamera in der elektrischen Maschine anzuordnen, statt die elektrische Maschine zu öffnen, was einen erheblichen Aufwand bedeuten würde. Die Minikamera wird mit einer geeigneten Übertragungsmöglichkeit, entweder durch drahtlose Übertragung oder mit drahtgebundener Übertragung mit einem Auswertesystem verbunden. Die elektrische Maschine kann daher von einem Beobachter, der außerhalb des Generators sich befindet, überwacht werden.

Vorteilhafte Weiterbildungen sind in den Unteransprüchen angegeben.

So wird in einer ersten vorteilhaften Weiterbildung das Gehäuse im Wesentlichen gasdicht geschlossen ausgeführt. Des Weiteren wird vorteilhafterweise die elektrische Maschine mit einer Wasserstoffkühlung ausgeführt. Das bedeutet, dass das erfindungsgemäße Überwachungssystem besonders geeignet ist für Wasserstoff gekühlte Generatoren, die bekanntermaßen ja besonders gasdicht ausgebildet sind. In einer weiteren vorteilhaften Weiterbildung wird die Minikamera mit einer Lichtquelle ausgeführt. Diese Lichtquelle müsste derart dimensioniert sein, dass die mit der Kamera notwendige Einsicht auf die zu betrachtenden Elemente bzw. Komponenten in der elektrischen Maschine garantiert ist.

Die Minikamera wird vorteilhafterweise auf Führungselementen bewegbar angeordnet. Diese Führungselemente können als Schienen ausgebildet sein und werden so gestaltet, dass eine Führung der Kamera derart erfolgen kann, dass die notwendige Einsicht auf die zu betrachtenden kritischen Elemente bzw. Komponenten garantiert ist.

Vorteilhafterweise ist das Führungselement unmagnetisch ausgebildet. Des Weiteren wird die Führungsschiene derart angeordnet, dass die Kamera in Betrieb in einer sicheren und unkritischen Parkstellung angeordnet ist. Diese Parkstellung wird derart gewählt, dass die Spannungsabstände eingehalten werden und außerdem die herrschenden mechanischen Belastungen, wie z.B. Kühlgasströmungen betrachtet werden. Somit kann die Kamera in einer sicheren Position gehalten werden.

Vorteilhafterweise wird die das Führungselement in Kreisbahnen um den Ständerwickelkopf geführt.

Im Folgenden wird die Erfindung anhand eines Ausführungsbeispieles nun näher erläutert.

Es zeigt:

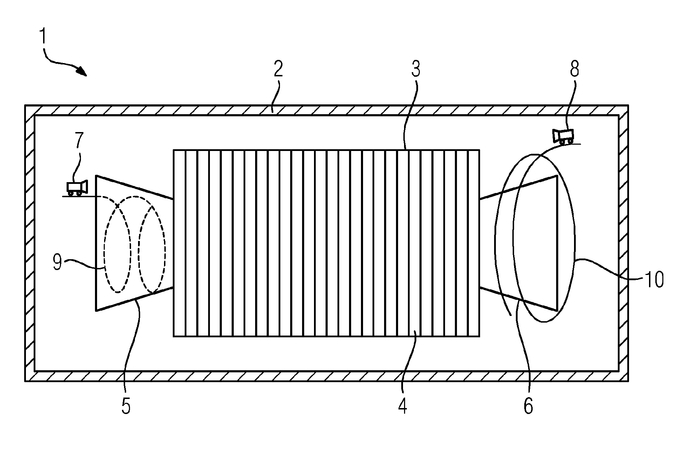

Figur 1 eine schematische Ansicht des Überwachungssystems.

Die Figur 1 zeigt in schematischer Weise einen elektrischen Generator 1. Der elektrische Generator 1 umfasst im Wesentlichen ein Generatorgehäuse 2, das im Wesentlichen gasdicht geschlossen ist. Innerhalb des Generatorgehäuses 2 ist ein nicht näher dargestellter Rotor drehbar angeordnet, der im Wesentlichen bei 50 Hz bzw. 60 Hz rotiert. Um den Rotor ist eine Ständerwicklung 3 und ein Blechpaket 4 angeordnet, in dem eine elektrische Spannung induziert werden kann. An den jeweiligen Enden der Ständerwicklung 3 sind ein erster Ständerwickelkopf 5 und ein zweiter Ständerwickelkopf 6 angeordnet. Sowohl der erste Ständerwickelkopf 5 als auch der zweite Ständerwickelkopf 6 neigen in Betrieb zu unerwünschten Schwingungen. Im schlimmsten Fall können solche Schwingungen eine Zerstörung des ersten Ständerwickelkopfes 5 und des zweiten Ständerwickelkopfes 6 bewirken.

Über nicht näher dargestellte Kühlmöglichkeiten wird innerhalb des Generatorgehäuses 2 die Ständerwicklung 3 mit bspw. Wasserstoff gekühlt. Daher ist das Generatorgehäuse 2 gasdicht ausgeführt. Das Überwachungssystem zur Überwachung der elektrischen Maschine 1 umfasst die elektrische Maschine 1 und das Generatorgehäuse 2, wobei im Generatorgehäuse 2 eine Ständerwicklung angeordnet ist, umfassend einen Ständerwickelkopf 5, 6. Innerhalb des Generatorgehäuses 2 ist eine Minikamera 7, 8 angeordnet, die zur Beobachtung der elektrischen Maschine 1, insbesondere des ersten Ständerwickelkopfes 5 als auch des zweiten Ständerwickelkopfes 6 ausgebildet ist. Die Minikamera 7, 8 ist mit einer nicht näher dargestellten Lichtquelle ausgeführt und auf Führungselementen 9, 10 bewegbar angeordnet. Diese Führungselemente 9, 10 sind als Schienen ausgebildet und zweckmäßigerweise unmagnetisch ausgeführt, da die im elektrischen Generator 1 herrschenden Magnetfelder zu Störungen führen könnten.

Die Führungselemente 9, 10 sind in Kreisbahnen um den ersten Ständerwickelkopf 5 als auch um den zweiten Ständerwickelkopf 6 geführt.

In nicht näher dargestellter Weise sind die Führungselemente 9, 10 derart ausgebildet, dass während des Betriebs der elektrischen Maschine 1 die Minikamera 7, 8 in einer unkritischen Parkposition gehalten ist.

Der Vorteil der Erfindung ist, dass der elektrische Generator 1 im Falle einer visuellen Inspektion nicht geöffnet bzw. nicht teildemontiert werden muss. Des Weiteren muss der wasserstoffgekühlte elektrische Generator 1 nicht ausgeblasen und nach Verschließen wieder abgedrückt werden. Die Inspektion durch das erfindungsgemäße Überwachungssystem zeigt eine verbesserte Qualität durch definierte und gleichbleibende Betrachtung der Komponenten.

Darüber hinaus ist mit der erfindungsgemäßen Überwachungseinheit eine große Zeiteinsparung möglich. Dadurch ist eine resultierende bessere Trendbetrachtung möglich. Außerdem werden keine Ersatzteile beim Verschließen des Generators 1 bspw. Dichtungen oder neue Verschraubungselemente notwendig sein.

## Patentansprüche

1. Überwachungssystem zur Überwachung einer elektrischen Maschine (1),
wobei die elektrische Maschine (1) ein Generatorgehäuse (2) und eine im Generatorgehäuse (2) angeordnete Ständerwicklung (3) mit einem Ständerwickelkopf (5, 6) aufweist, wobei innerhalb des Generatorgehäuses (2) eine Minikamera (7, 8) zur Beobachtung der elektrischen Maschine (1) angeordnet ist.

2. Überwachungssystem nach Anspruch 1,
wobei das Generatorgehäuse (2) im Wesentlichen gasdicht geschlossen ausgeführt ist.

3. Überwachungssystem nach Anspruch 1 oder 2,
wobei die elektrische Maschine (1) mit einer Wasserstoffkühlung ausgeführt ist.

4. Überwachungssystem nach einem der vorhergehenden Ansprüche,
wobei die Minikamera (7, 8) mit Lichtquelle ausgeführt ist.

5. Überwachungssystem nach einem der vorhergehenden Ansprüche,
wobei die Minikamera (7, 8) auf Führungselementen (9, 10) bewegbar angeordnet ist.

6. Überwachungssystem nach Anspruch 5,
wobei das Führungselement (9, 10) als Schiene ausgebildet ist.

7. Überwachungssystem nach Anspruch 5 oder 6,
wobei das Führungselement (9, 10) unmagnetisch ausgebildet ist.

8. Überwachungssystem nach einem der Ansprüche 5 bis 7,
wobei das Führungselement (9, 10) in Kreisbahnen um den Ständerwickelkopf (5, 6) geführt ist.

9. Überwachungssystem nach einem der vorhergehenden Ansprüche,
wobei das Führungselement (9, 10) derart ausgebildet ist, dass während des Betriebs der elektrischen Maschine (1) die Minikamera (7, 8) in einer unkritischen Parkposition gehalten ist.

10. Überwachungssystem nach einem der vorhergehenden Ansprüche,
geeignet zur Überwachung einer als elektrischer Generator ausgeführten elektrischen Maschine (1).
